Europäisches Patentamt

European Patent Office

Office européen des brevets

(19)

(11) Veröffentlichungsnummer: **0 316 765 B1**

(12) **EUROPÄISCHE PATENTSCHRIFT**

(45) Veröffentlichungstag der Patentschrift: **01.06.94**

(51) Int. Cl.[5]: **H01L 21/306**

(21) Anmeldenummer: **88118739.7**

(22) Anmeldetag: **10.11.88**

(54) **Verfahren zur hydrophilierenden und/oder Kittreste entfernenden Oberflächenbehandlung von Siliciumscheiben.**

(30) Priorität: **13.11.87 DE 3738651**

(43) Veröffentlichungstag der Anmeldung:
**24.05.89 Patentblatt 89/21**

(45) Bekanntmachung des Hinweises auf die
Patenterteilung:
**01.06.94 Patentblatt 94/22**

(84) Benannte Vertragsstaaten:
**DE FR GB IT**

(56) Entgegenhaltungen:
**US-A- 4 339 340**

**IBM TECHNICAL DISCLOSURE BULLETIN,
Band 27, Nr. 10A, März 1985, Seiten
5602-5603; New York, US.: "Improved organic
clean for removing contaminants on semiconductor wafer surfaces"**

(73) Patentinhaber: **Wacker-Chemitronic Gesellschaft für Elektronik-Grundstoffe mbH
Johannes-Hess-Strasse 24
D-84489 Burghausen(DE)**

(72) Erfinder: **Brunner, Roland
Hofmark 11
D-8399 Stubenberg(DE)**
Erfinder: **Bauer-Mayer, Susanne, Dr.
Dipl.-Chem.
Lindacher Strasse 67
D-8263 Burghausen(DE)**
Erfinder: **Griesshammer, Rudolf, Dr.
Dipl.-Chem.
Megerleweg 6
D-8262 Altötting(DE)**
Erfinder: **Kirschner, Helmut, Ing. grad.
Göllstrasse 2
D-8261 Emmerting(DE)**

Rank Xerox (UK) Business Services
(3.10/3.09/3.3.3)

**Beschreibung**

Die Erfindung betrifft ein Verfahren zur hydrophilierenden und/oder Kittreste entfernenden Oberflächenbehandlung von Siliciumscheiben durch Einwirken von alkalischen, wasserstoffperoxidhaltigen wäßrigen Lösungen.

Für die Herstellung von elektronischen Bauelementen aus Silicium werden in den meisten Fällen Siliciumscheiben mit zumindest einer hydrophilen Scheibenoberfläche eingesetzt. Die hydrophilen Eigenschaften der Oberflächen, die sich qualitativ beispielsweise am Ablaufverhalten eines aufgebrachten Wassertropfens erkennen lassen, werden dabei meist im Rahmen der Behandlungsschritte erzeugt, die im Anschluß an den Poliervorgang zur Entfernung anhaftender Kittreste von den Scheiben und zu ihrer endgültigen Reinigung durchgeführt werden, bevor die Scheiben dann verpackt und zum Versand oder zur Lagerung weitergleitet werden.

Für diese Behandlung der polierten Scheiben hat sich weithin eine Sequenz von Einzelschritten durchgesetzt, die im Grunde auf ein von W. Kern und D. Puotinen, RCA Review, June 1970, Seite 187 bis 206 beschriebenes Reinigungsverfahren (sogenannte "RCA-Reinigung") zurückgeht. Dabei werden anhaftende Kittreste mit organischen Lösungsmitteln, wie z.B. Trichlorethylen, entfernt, während der Hydrophilierungsschritt in der Weise durchgeführt wird, daß die Siliciumscheiben in ein eine wäßrige ammoniakalische Wasserstoffperoxidlösung enthaltendes Bad eingetaucht werden.

Diese Verfahrensweise ist jedoch in mancher Hinsicht nachteilig. Zum einen erfordert das Arbeiten mit Ammoniak - schon wegen der Geruchsbelästigung - aufwendige Abzugsanlagen. Des weiteren muß das Bad auf erhöhten Temperaturen meist 60° - 85°C) gehalten werden, um wirtschaftlich noch vertretbare Behandlungszeiten zu erreichen. Dies hat eine erhöhte Flüchtigkeit des Ammoniaks zur Folge, sodaß einerseits ständig Ammoniak nachgeliefert werden muß und somit der Chemikalienbedarf dementsprechend hoch ist, während andererseits die im Bad vorliegende Ammoniakkonzentration andauernden Schwankungen unterworfen ist, was wiederum nicht ohne Auswirkungen auf die empfindliche Scheibenoberfläche bleibt. Als besonders kritisch hat sich auch die Phase erwiesen, in der die Scheiben aus dem Bad herausgezogen werden und dabei dem Angriff des gasförmigen, ätzenden Ammoniaks in Abwesenheit des diese Reaktion kontrollierenden Wasserstoffperoxids ausgesetzt sind. Gleichermaßen nachteilig ist die gewöhnlich dem Hydrophilierungsschritt vorgeschaltete Entfernung der nach dem Poliervorgang an den Scheiben noch anhaftenden Kittreste mittels organischer, meist chlorhaltiger Lösungsmittel, wie z.B. Trichlorethylen. Dabei ist vor allem die mögliche gesundheitliche Gefährdung des Bedienungspersonals, die dadurch bedingten, apparativ aufwendigen Vorkehrungsmaßnahmen wie Abzüge und dgl., sowie die hohen Kosten derartiger Lösungsmittel zu nennen. Überdies ist es bei allen Lösungen schon wegen des hohen Dampfdruckes schwierig, störende Partikel durch Filtration aus den Bädern zu entfernen. Aus der Patentschrift US-4,339,340 sind Reinigungslösungen auf der Basis von Trialkyl(hydroxyalkyl)ammoniumhydroxid bekannt.

Die Aufgabe der Erfindung lag darin, ein Verfahren anzugeben, das die genannten Nachteile vermeidet und insbesondere bei niedrigen Temperaturen und unter geringem Chemikalieneinsatz durchgeführt werden kann.

Gelost wird die Aufgabe durch ein Verfahren gemäß Anspruch 1.

Für die Einstellung des pH-Wertes der wäßrigen Lösungen auf 8 - 14, vorzugsweise 9 - 12, können allgemein alkalisch reagierende Verbindungen der Alkali- oder Erdalkalimetalle verwendet werden, wobei dem Einsatz der letzteren durch die Bildung von unter den Reaktionsbedingungen schwer löslichen Niederschlägen, wie z.B. Carbonaten, Grenzen gesetzt sind. Neben den Hydroxiden eignen sich daher vor allem die mit schwachen Säuren gebildeten Salze, sofern sie nicht in unzulässiger Weise mit Wasserstoffperoxid reagieren. Bewährt haben sich insbesondere die Salze der Alkalimetalle, vor allem des Natriums und des Kaliums, mit Kohlenstoff enthaltenden Säuren, wie z.B. der Essig- oder Zitronensäure. Schon aus Kostengründen wird man bevozugt auf die Carbonate zurückgreifen, wobei vorteilhaft Natrium- und insbesondere Kaliumcarbonat eingesetzt wird. Günstig wirkt sich dabei vor allem auch aus, daß solche Carbonatlösungen im genannten pH-Bereich Pufferwirkung besitzen und daher besonders pH-stabil sind. Aus diesem Grund lassen sich auch andere, in diesen pH-Bereichen wirksame Puffersysteme, z.B. auf Phosphat- oder Boratbasis, mit besonderem Vorteil verwenden.

Die Konzentration der Alkali- oder Erdalkalimetallverbindungen in den erfindungsgemäß eingesetzten Lösungen kann gering gehalten werden. Oftmals werden schon im Konzentrationsbereich von 0,1 bis 10 Gew.-%, bevorzugt 0,3 bis 5 Gew.-% ausgezeichnete Ergebnisse erzielt. Grundsätzlich ist jedoch auch der Einsatz von stärker konzentrierten Lösungen bis hin zur Sättigung nicht ausgeschlossen, obwohl man im allgemeinen möglichst geringe Konzentrationen anwenden wird, schon um das Risiko einer Kontamination der Scheibenoberfläche durch das jeweils vorhandene Kation bzw. durch mit den jeweils eingesetzten Verbindungen eingeschleppte Schwermetallionen gering zu halten.

Zweckmäßig werden daher die Verbindungen wie z.B. Natrium-oder Kaliumcarbonat in möglichst reiner Form, das heißt, weitestgehend frei von schädlichen Schwermetallionen wie z.B. Eisen, Nickel, Zink, Kupfer oder Blei eingesetzt. Geeignete Verbindungen, bei denen der Anteil solcher störenden Ionen im Gewichts-ppm- oder -ppb-Bereich liegt, sind beispielsweise im Handel erhältlich. Für die Zubereitung der Lösungen eignet sich hochreines, beispielsweise durch ein-oder mehrfache Umkehrosmose entsalztes Wasser. Der Fremdionenanteil in solcherart gereinigten Wasser liegt typisch im Bereich von weniger als 10 Gew.-ppb. Auch das der Lösung beigemischte Wasserstoffperoxid wird zweckmäßig in möglichst reiner Form, also mit möglichst geringem Fremdionen-, insbesondere Schwermetallionenanteil eingesetzt. Geeignete Wasserstoffperoxidlösungen, bei welchen der Anteil an Verunreinigungen nur noch im Bereich von wenigen Gewichts-ppm oder darunter liegt, sind im Handel beispielsweise mit 30 Gew.-%-igem oder 5 Gew.-%-igem Peroxidanteil erhältlich. In diesem Zusammenhang ist es auch von Vorteil, daß der Wasserstoffperoxidanteil in der letztendlich eingesetzten Lösung gering gehalten werden kann und nur mindestens 0,1 Gew.-%, vorteilhaft 0,3 bis 5 Gew.-% beträgt. Auf diese Weise wird durch den Verdünnungseffekt eine weitere Erniedrigung des Verunreinigungsanteils erzielt.

Zweckmäßig werden die Lösungen in der jeweils gewählten Zusammensetzung vorbereitet und können dann, gegebenenfalls nach einem oder mehreren Filtrationsschritten zur weiteren Reduzierung von partikelförmigen Verunreinigungen, bei der Hydrophilierung und/oder der Entfernung der Kittreste eingesetzt werden. Eine Möglichkeit besteht beispielsweise darin, die Lösung in Form eines Tauchbades vorzulegen, in welches dann die zu behandelnden Scheiben zumeist in Prozesshorden zusammengefaßt eingetaucht werden. Die erforderlichen Verweilzeiten sind auch bei Raumtemperatur gering; zumeist ist bereits innerhalb von 1 bis 300 Sekunden eine ausreichende Hydrophilierung oder Entkittung der Scheibenoberfläche zu erreichen. Gegebenenfalls lassen sich die Verweilzeiten durch den Einsatz von temperierten, z.B. thermostatisierten, Bädern weiter verringern. Allgemein haben sich Badtemperaturen im Bereich von 15° bis 40°C bewährt, wobei diese Angabe nicht im Sinne einer Beschränkung zu verstehen ist. Der Einsatz von auf höheren Temperaturen gehaltenen Lösungen bis in deren Siedebereich ist jedoch nicht ausgeschlossen und kann beispielsweise in Fällen erforderlich sein, in denen eine besonders rasche Hydrophilierung und/oder Entkittung angestrebt wird. Grundsätzlich sollte im Interesse reproduzierbarer Ergebnisse insbesondere bei der Hydrophilierung auf möglichst geringe Temperaturschwankungen geachtet werden.

Bei dem erfindungsgemäßen Verfahren kann die die Hydrophilierung und/oder Entkittung bewirkende Lösung nicht nur durch eine Tauchbehandlung zur Einwirkung auf die Scheibenoberfläche gebracht werden. Gleichermaßen eignen sich beispielsweise auch Sprühbäder, in denen das jeweils ausgewählte Hydrophilierungsmittel mittels Düsen auf die zu behandelnde Oberfläche gesprüht wird. In solchen Sprühbädern ist gewöhnlich eine besonders rasche Hydrophilierung möglich, ebenso wie die Zusammenfassung von Hydrophilierungs- und Entkittungsschritt zu einem einzigen Prozeßschritt.

Gegebenenfalls können den für die Hydrophilierung und/oder Entkittung verwendeten Lösungen auch Tenside zugesetzt werden, um die Ablösung von Partikeln von der Scheibenoberfläche zu erleichtern, oder deren Ablagerung auf den Scheibenoberflächen zu verhindern. Geeignete Tenside sind beispielsweise Verbindungen auf Alkylphenolbasis, wie z.B. Nonylphenolpolyglykolether oder auf Alkyl- oder Alkylarylsulfonatbasis. Derartige Tenside können auch wegen der Eigenschaft, die Scheibenoberfläche vor dem Angriff der alkalischen Komponente zu schützen, verwendet werden.

Eine besonders rasche Hydrophilierung kann erzielt werden, wenn die Scheiben vor der eigentlichen Behandlung kurzzeitig mit einer Flußsäure enthaltenden Lösung in Kontakt gebracht werden, beispielsweise durch Eintauchen. Dabei sind bereits Flußsäurekonzentrationen ab etwa 0,3 Gew.-% ausreichend, wenngleich auch höhere Werte bis hin zu konzentrierten Lösungen nicht ausgeschlossen sind. Die Zeitdauer der Vorbehandlung beträgt zweckmäßig 10 bis 100 Sekunden, die dabei eingestellte Temperatur vorteilhaft 15° bis 45°C.

Die Behandlung der Oberflächen von Siliciumscheiben zur Hydrophilierung und/oder Entfernung von aus dem Poliervorgang stammenden Kittresten unter Verwendung von auf einen pH-Wert von 8 bis 14 mit Hilfe von Alkali- oder Erdalkaliverbindungen eingestellten, mindestens 0,1 Gew.-% Wasserstoffperoxid enthaltenden Lösungen hat gegenüber den bekannten Verfahren deutliche Vorteile. Beispielsweise ist der Chemikalienverbrauch äußerst gering, da die benötigten Substanzen in sehr geringen Konzentrationen eingesetzt werden können und nur das Wasserstoffperoxid im Verlauf der Behandlung langsam aufgebraucht wird. Ferner ermöglicht der Prozess bereits bei Raumtemperatur kurze Behandlungszeiten, sodaß auf Heiz- und Thermostatisiersysteme und Vorheizen der benötigten Lösungen verzichtet werden kann, wodurchgleichzeitig thermische Belastungen der Scheiben beim Kontakt mit der Lösung vermieden werden. Da schließlich die Lösungen keine schädlichen Abgase freisetzen, können auch die daraus resultierenden und eingangs erläuterten Nachteile vermieden werden. Des weiteren zeigen die nach dem erfindungsgemäßen Verfahren hydrophilierten und/oder von Kittresten befreiten Siliciumscheiben bei nachgeschalteten Reinigungsschritten im Rahmen der Standard-Reinigungsprozesse ausgezeichnete Eigenschaften. Beispielsweise lassen sie sich mit Hilfe der üblichen Methode zur Entfernung von anhaftenden Partikeln mittels beschichteter Walzen in einen einwandfrei partikelfreien Zustand überführen. Darüber hinaus wurde auch gefunden, daß diese Siliciumscheiben sich bei nachgeschalteten Oxidationsprozessen gegenüber den in herkömmlicher Weise hydrophilierten Scheiben als zumindest gleichwertig erweisen.

Ein besonderer Vorteil liegt darin, daß im Rahmen des an den Poliervorgang sich anschließenden Reinigungsprozesses für die Entkittung und Hydrophilierung der Scheiben Lösungen gleicher oder ähnlicher Zusammensetzung eingesetzt werden können. Damit kann die Gefahr des Einschleppens störender Fremdionen gering gehalten werden. Eine mögliche Prozessfolge kann beispielsweise eine erste Behandlung in einem Entkittungsbad und eine zweite Behandlung in einem Hydrophilierungsbad vorsehen, wobei in beiden Bädern gleich oder verschieden konzentrierte, z.B. mittels Kaliumcarbonat alkalisch gestellte Wasserstoffperoxidlösungen vorgelegt sind. Gegebenenfalls kann zwischen diese beiden Schritte eine Behandlung mit Flußsäure zwischengeschaltet sein, der zweckmäßig noch Spülschritte mit Wasser vor- bzw. nachgeschaltet sein können. Grundsätzlich ist es jedoch nicht zwingend vorgeschrieben, bei einem in zwei Einzelschritte aufgeteilten Prozeßverlauf beide Teilschritte, das heißt, den Hydrophilierungsschritt und den Entkittungsschritt nach dem erfindungsgemäßen Verfahren durchzuführen. Es ist gleichfalls nicht ausgeschlossen, jeweils für einen der beiden Teilschritte eine andere Methode anzuwenden, also beispielsweise die Entkittung mittels Trichlorethylen oder die Hydrophilierung mittels Ammoniak/Wasserstoffperoxid. Eine solche Entkittung wird man vor allem in den Fällen durchführen, in denen Kitte eingesetzt werden, die von alkalischen Lösungen nicht oder nicht in einem zur Ablösung ausreichenden Maß angegriffen werden. Hingegen eignet sich die erfindungsgemäße Entkittungsmethode insbesondere zur Entfernung von Resten von im alkalischen Bereich löslichen Kitten, wie z.B. auf Basis von Maleinat- oder Phthalatharzen oder hydroxylgruppenhaltigen verzweigten Polyestersystemen oder auch Schellack. Gleichfalls möglich ist es jedoch auch, gemäß einer Weiterbildung des Erfindungsgedankens, beide Teilschritte in einen einzigen Arbeitsgang zusammengefaßt, das heißt z.B. in nur einem Sprühbad, durchzuführen.

Nachstehend wird das erfindungsgemäße Verfahren anhand von Ausführungsbeispielen näher erläutert:

Beispiel 1:

In einem üblicherweise zur Hydrophilierung von Siliciumscheiben verwendeten temperierbaren Tauchbad (Badinhalt ca. 100 Liter) wurden bei verschiedenen Temperaturen und Konzentrationen Lösungen verschiedener alkalisch reagierender Verbindungen der Alkalimetalle Natrium und Kalium vorgelegt, deren pH-Wert (gemessen mittels pH-Elektrode) im Bereich von 9-14 lag. Die Lösungen enthielten verschieden hohe Anteile von Wasserstoffperoxid sowie ggf. noch Anteile eines Tensids. In diese Lösungen wurden jeweils 2 Prozeßhorden mit je 25 zu hydrophilierenden Scheiben eingetaucht und für verschiedene Verweilzeiten im Bad belassen. Die Oberflächen dieser Scheiben besaßen hydrophobe Eigenschaften, d.h. ein auf die Scheibe aufgebrachter Wassertropfen lief ab, ohne die Scheibe zu benetzen. Die bei den einzelnen Versuchsreihen eingehaltenen Bedingungen sind in der Tabelle dargestellt.

Jeweils im Anschluß an diese Behandlung wurden die entnommenen Scheiben mit vollentsalztem und durch Umkehrosmose gereinigtem Wasser gereinigt. Alle erhaltenen Siliciumscheiben besaßen hydrophile Eigenschaften, was daran zu erkennen war, daß die Oberflächen vollständig mit Wasser benetzt waren. Von den mit kaliumhaltigen Lösungen behandelten Scheiben wurden anschließend stichprobenartig jeweils fünf mit Hilfe der Röntgenfluoreszenzanalyse auf eine etwaige Kontamination der Scheibenoberfläche mit Kalium untersucht. Bei allen Scheiben lag die Kaliumoberflächenbelegung unterhalb der Nachweisgrenze von etwa $1.10^{11}$ Atomen/cm$^2$.

Von den mit Kaliumcarbonat behandelten Scheiben wurden jeweils 20 Stück in der üblichen Weise verpackt und dann für 6 Monate gelagert. Danach wurden die Scheiben entnommen und durch Eintauchen in Wasser auf die hydrophilen Eigenschaften der Oberfläche untersucht. Alle Scheiben erwiesen sich als einwandfrei hydrophil.

Beispiel 2:

Analog der in Beispiel 1 beschriebenen Vorgehensweise wurden Siliciumscheiben behandelt, die einer Einseitenpolitur unterworfen worden waren und auf ihrer Rückseite noch Spuren des zum Aufkitten auf den Polierteller verwendeten Kittes (auf Maleinatharzbasis) trugen, die bei Betrachtung unter dem Fluoreszenzmikroskop deutlich als fluoreszierende Teilchen sichtbar waren. Wieder wurden die in der Tabelle zusammengestellten Verfahrensparameter eingehalten.

Nach der Behandlung und Reinigung mit vollentsalztem und durch Umkehrosmose gereinigtem Wasser wurden die Scheibenrückseiten erneut unter dem Fluoreszenzmikroskop untersucht. Es konnten keine Kittrückstände mehr festgestellt werden. Außerdem erwiesen sich die Oberflächen aller erhaltenen Scheiben als hydrophil.

Beispiel 3:

In einer Prozeßhorde wurden 25 polierte Siliciumscheiben für eine Hydrophilierung vorgesehen, die vorher für etwa 30 Sekunden in eine ca. 0.5 gew%ige Flußsäurelösung eingetaucht worden waren. In einer Kontrollhorde wurden 25 ansonsten identisch vorbehandelte Siliciumscheiben vorgelegt, an denen jedoch keine Flußsäurebehandlung durchgeführt worden war. Beide Scheibengruppen besaßen hydrophobe Scheibenoberflächen.

Nun wurden beide Horden für ca. 15 Sekunden in ein Hydrophilierungsbad eingetaucht, in dem eine ca. 1 gew%ige Kaliumcarbonatlösung (pH ca. 10.5) mit einem $H_2O_2$-Gehalt von ca. 1Gew% auf einer Temperatur von etwa 25°C gehalten wurde. Nach Entnahme der Scheiben erwiesen sich nur die mit Flußsäure vorbehandelten als vollständig hydrophiliert.

Die nicht mit Flußsäure vorbehandelte Scheibengruppe wurde nun erneut für weitere 20 Sekunden in das Hydrophilierungsbad getaucht. Danach waren auch diese Scheiben vollständig hydrophiliert.

Beispiel 4:

In einem Test zur Untersuchung der Durchschlagsfestigkeit von auf den Scheiben erzeugten dünnen Oxidschichten wurden zwei Scheibengruppen von je 5 Siliciumscheiben durch einstündige Oxidation in einer sauerstoffhaltigen Inertgasatmosphäre bei ca. 900 °C mit einer 250 A dicken Oxidschicht versehen. Beide Scheibengruppen waren vorher im Anschluß an den Polierprozeß in gleicher Weise einer Reinigungssequenz unterzogen worden, mit dem Unterschied, daß bei der einen Scheibengruppe die Kittentfernung und die Hydrophilierung mit Hilfe von auf 55 °C gehaltener, ca. 1 Gew% Wasserstoffperoxid enthaltender, ca. 5 gew%iger Ammoniaklösung durchgeführt wurde, während bei der anderen Gruppe dazu auf ca. 25 °C gehaltene, ca. 1 Gew% Wasserstoffperoxid enthaltende, ca 1. gew%ige Kaliumcarbonatlösung eingesetzt wurde.

Im Anschluß an die Oxidation wurde auf den Scheiben mit Hilfe von aufgebrachten Masken eine polykristalline Siliciumschicht in der Weise abgeschieden, daß auf der Oxidschicht jeweils 50 quadratische Bereiche mit je 100 mm$^2$ Fläche aus polykristallinem Silicium vorlagen. Durch jeden dieser Bereiche wurde nun für eine Zeitdauer von 500 msec ein Strom mit einer Stärke von 6 mA geschickt und anschließend die Zahl derjenigen Bereiche festgestellt, bei denen diese Behandlung nicht zu einem Durchbruch geführt hatte. Bei den mit ammoniakhaltigen Lösungen behandelten Scheiben lag dieser Anteil zwischen ca. 70 und 90 %, bei den mit kaliumcarbonathaltigen Lösungen behandelten Scheiben bei ca. 85 bis 98 %.

Tabelle: Verwendete Reagentien und Verfahrensparameter bei der Hydrophilierung bzw. Entfernung von Kittresten

| | $K_2CO_3$ | | | $Na_2CO_3$ | | | Natrium-acetat | | | KOH | | | $K_2CO_3$/KOH | | | Natrium-borat / Natron-lauge |
|---|---|---|---|---|---|---|---|---|---|---|---|---|---|---|---|---|
| Konzentration (Gew.-%) | 0.5 | 5 | 10 | 0.5 | 5 | 10 | 0.5 | 5 | 10 | 0.5 | 5 | 10 | 0.5 / 0.5 | | | 5 / 4 |
| pH | 10.5 | 11.5 | 11.5 - 12 | 10.5 | 11.5 | 11.5 - 12 | 9 | 9-9.5 | 9-9.5 | 12 | 13.5 | 14 | 14 | | | 10.8 |
| Temperatur (°C) | 20 | 40 | 80 | 20 | 40 | 80 | 20 | 40 | 80 | 20 | 40 | 80 | 20 | 40 | 80 | 40 |
| Verweilzeit (sec) | 300 | 10 | 2 | 300 | 10 | 2 | 300 | 10 | 2 | 300 | 10 | 2 | 300 | 10 | 2 | 10 |
| $H_2O_2$-Anteil (Gew.-%) | 0.5 | 1 | 10 | 0.5 | 1 | 10 | 0.5 | 1 | 10 | 0.5 | 1 | 10 | 0.5 | 1 | 10 | 1 |
| Nonyl-phenol-polygly-kolether (Gew.-%) | — | 0.5 | — | — | 0.5 | — | — | 0.5 | — | — | 0.5 | — | — | 0.5 | — | — |

## Patentansprüche

1. Verfahren zur hydrophilierenden und/oder Kittreste entfernenden Oberflächenbehandlung von Siliciumscheiben durch Einwirken von alkalischen,

wasserstoffperoxidhaltigen wäßrigen Lösungen, dadurch gekennzeichnet, daß zumindest eine wäßrige Lösung zur Einwirkung auf die Scheibenoberfläche gebracht wird, welche einen Mindestgehalt von 0,1 Gew.-% Wasserstoffperoxid aufweist, mit Hilfe von Verbindungen der Alkali- oder Erdalkalimetalle auf einen pH-Wert von 8-14 eingestellt ist und nur nach gegebenenfalls Tenside als weitere Zusätze enthält.

2. Verfahren nach Anspruch 1, dadurch gekennzeichnet, daß der pH-Wert der wäßrigen Lösung auf 9 - 12 eingestellt wird.

3. Verfahren nach den Ansprüchen 1 oder 2, dadurch gekennzeichnet, daß zur Einstellung des pH-Wertes Alkalimetallsalze von Kohlenstoff enthaltenden Säuren eingesetzt werden.

4. Verfahren nach einem oder mehreren der Ansprüche 1 bis 3, dadurch gekennzeichnet, daß zur Einstellung des pH-Wertes Kalium- oder Natriumsalze der Kohlen-, Essig- oder Zitronensäure eingesetzt werden.

5. Verfahren nach einem der oder mehreren der Ansprüche 1 bis 4, dadurch gekennzeichnet, daß die Lösung auf einer Temperatur von 15° bis 40°C gehalten wird.

6. Verfahren nach einem oder mehreren der Ansprüche 1 bis 5, dadurch gekennzeichnet, daß die Konzentration der Verbindungen der Alkali- oder Erdalkalimetalle in der Lösung auf 0,1 bis 10 Gew.-% eingestellt wird.

7. Verfahren nach einem oder mehreren der Ansprüche 1 bis 6, dadurch gekennzeichnet, daß die Siliciumscheiben vor der Hydrophilierung mit einer Flußsäure enthaltenden Lösung behandelt werden.

8. Verfahren nach einem oder mehreren der Ansprüche 1 bis 7, dadurch gekennzeichnet, daß die hydrophilierende und die Kittreste entfernende Behandlung in getrennten Teilschritten durchgeführt werden.

9. Verwendung von mit Hilfe von Verbindungen der Alkali- oder Erdalkalimetalle auf einen pH-Wert von 8 bis 14 eingestellten, mindestens 0,1 Gew.-% Wasserstoffperoxid und nur nach gegebenenfalls Tenside als weitere Zusätze enthaltenden wäßrigen Lösungen zur Erzeugung von hydrophilen Oberflächen auf Siliciumscheiben.

10. Verwendung von mit Hilfe von Verbindungen der Alkali- oder Erdalkalimetalle auf einen pH-Wert von 8 bis 14 eingestellten, mindestens 0,1 Gew.-% Wasserstoffperoxid und nur nach gegebenenfalls Tenside als weitere Zusätze enthaltenden wäßrigen Lösungen zur Entfernung von an der Oberfläche von Siliciumscheiben anhaftenden Kittresten.

**Claims**

1. Process for the hydrophilizing and/or cement-residue-removing surface treatment of silicon slices by the action of alkaline aqueous solutions containing hydrogen peroxide, characterized in that at least one aqueous solution is caused to act on the slice surface which solution has a minimum hydrogen peroxide content of 0.1% by weight and has been adjusted to pH of 8-14 with the aid of compounds of the alkali or alkaline-earth metals and optionally containing, as further additives, only surfactants.

2. Process according to Claim 1, characterized in that the pH of the aqueous solution is adjusted to 9 - 12.

3. Process according to Claim 1 or 2, characterized in that alkali-metal salts of carbon-containing acids are used to adjust the pH.

4. Process according to one or more of Claims 1 to 3, characterized in that potassium or sodium salts of carbonic, acetic or citric acid are used to adjust the pH.

5. Process according to one or more of Claims 1 to 4, characterized in that the solution is held at a temperature of 15° to 40°C.

6. Process according to one or more of Claims 1 to 5, characterized in that the concentration of the compounds of the alkali or alkaline-earth metals in the solution is adjusted to 0.1 to 10% by weight.

7. Process according to one or more of Claims 1 to 6, characterized in that the silicon slices are treated with a solution containing hydrofluoric acid before the hydrophilization.

8. Process according to one or more of Claims 1 to 7, characterized in that the hydrophilizing and cement-residue removing treatments are carried out in separate sub-steps.

9. Use of aqueous solutions adjusted to a pH of 8 to 14 with the aid of compounds of the alkali or alkaline-earth metals and containing at least 0.1% by weight of hydrogen peroxide and optionally containing, as further additives, only surfactants for producing hydrophilic surfaces on silicon slices.

10. Use of aqueous solutions adjusted to a pH of 8 to 14 with the aid of compounds of the alkali or alkaline earth-metals and containing at least 0.1% by weight of hydrogen peroxide and optionally containing, as further additives, only surfactants for the removal of cement residues adhering to the surface of the silicon slices.

**Revendications**

1. Procédé de traitement de la surface de plaquettes de silicium pour la rendre hydrophile et/ou en enlever des restes de mastic, par action de solutions aqueuses alcalines contenant du peroxyde d'hydrogène, caractérisé en ce qu'on apporte au moins une solution aqueuse destinée à agir sur la surface des plaquettes, solution qui présente une teneur minimale en peroxyde d'hydrogène de 0,1 % en poids, qui est portée à une valeur de pH de 8 à 14 à l'aide de composés de métaux alcalins et alcalino-terreux, et qui contient en outre seulement le cas échéant comme autres additifs des agents de surface.

2. Un procédé selon la revendication 1, caractérisé en ce que la valeur de pH de la solution aqueuse est placée entre 9 et 12.

3. Procédé selon les revendications 1 ou 2, caractérisé en ce que l'on utilise pour parvenir à la valeur de pH, des sels alcalino-métalliques d'acides contenant du carbone.

4. Procédé selon l'une ou plusieurs des revendications 1 à 3, caractérisé en ce que l'on utilise pour l'obtention de la valeur du pH, des sels de potassium ou de sodium de gaz carbonique, d'acides acétique ou citrique.

5. Procédé selon l'une ou plusieurs des revendications 1 à 4, caractérisé en ce que la solution est maintenue à une température de 15° à 40°C.

6. Procédé selon l'une ou plusieurs des revendications 1 à 5, caractérisé en ce que la concentration des composés de métaux alcalins et alcalino-terreux dans la solution est située entre 0,1 et 10 % en poids.

7. Procédé selon l'une ou plusieurs des revendications 1 à 6, caractérisé en ce que les plaquettes de silicium sont traitées au moyen d'une solution contenant de l'acide fluorhydrique, avant d'être rendues hydrophiles.

8. Procédé selon l'une ou plusieurs des revendications 1 à 7, caractérisé en ce que les traitements pour rendre les plaquettes hydrophiles d'une part, et en enlever des restes de mastic d'autre part, sont réalisés en des étapes séparées.

9. Utilisation de solutions aqueuses contenant au moins 0,1 % en poids de peroxyde d'hydrogène et seulement le cas échéant comme autres additifs des agents de surface, solution placée à une valeur de pH de 8 à 14 au moyen de composés de métaux alcalins et alcalino-terreux, pour la protection de surface hydrophile de plaquettes de silicium.

**10.** Utilisation de solutions aqueuses contenant au moins 0,1 % en poids de peroxyde d'hydrogène et seulement le cas échéant comme autres additifs des agents de surface, solution portée à une valeur de pH de 8 à 14 au moyen de composés de métaux alcalins et alcalino-terreux, pour l'élimination des restes de mastic adhérents à la surface des plaquettes de silicium.